# FASCICULE DE BREVET EUROPEEN

(11) **EP 3 577 683 B1**
(45) Date de publication et mention de la délivrance du brevet: **21.09.2022**
(21) Numéro de dépôt: 18705431.7
(22) Date de dépôt: 29.01.2018
(51) Int. Cl.: H01L 21/762, H01L 29/786, H01L 29/66, H01L 29/78

(54) **STRUCTURE POUR APPLICATION RADIOFRÉQUENCE**
STRUKTUR FÜR FUNKFREQUENZANWENDUNGEN
STRUCTURE FOR A RADIO FREQUENCY APPLICATION

(30) Priorité: 02.02.2017 FR 1750870
(43) Date de publication de la demande: 11.12.2019
(73) Titulaire: Soitec, 38190 Bernin (FR)
(72) Inventeur: DESBONNETS, Eric, 38660 Lumbin (FR); ASPAR, Bernard, 38330 Saint Ismier (FR)
(74) Mandataire: IP Trust
(86) Numéro de dépôt international: PCT/FR2018/050196
(87) Numéro de publication internationale: WO 2018/142052

(56) Documents cités:
- WO-A1-2010/108807
- WO-A1-2016/016532
- WO-A1-2016/087728
- WO-A1-2016/161029
- US-A1- 2004 129 977
- US-A1- 2016 336 991
- US-B1- 9 514 987

## Description

### DOMAINE DE L'INVENTION

La présente invention concerne les structures pour applications radiofréquences. Elle concerne notamment une structure de type silicium sur isolant comprenant une couche de piégeage et une électrode enterrée.

### ARRIERE PLAN TECHNOLOGIQUE DE L'INVENTION

Les dispositifs intégrés sont usuellement élaborés sur des substrats en forme de plaquettes, qui servent principalement de support à leur fabrication. L'accroissement du degré d'intégration et des performances attendues de ces dispositifs entraine un couplage de plus en plus important entre leurs performances et les caractéristiques du substrat sur lequel ils sont formés. C'est particulièrement le cas des dispositifs radiofréquence (RF), traitant des signaux dont la fréquence est comprise entre environ 3kHz et 300GHz, qui trouvent notamment leur application dans le domaine des télécommunications (téléphonie cellulaire, Wi-Fi, Bluetooth...).

A titre d'exemple de couplage dispositif/substrat, les champs électromagnétiques, issus des signaux hautes fréquences se propageant dans les dispositifs, pénètrent dans la profondeur du substrat et interagissent avec les éventuels porteurs de charge qui s'y trouvent. Il s'en suit des problèmes de distorsion non linéaire du signal (harmoniques), une consommation inutile d'une partie de l'énergie du signal par perte d'insertion et des influences possibles entre composants.

Parmi les substrats adaptés à l'élaboration de dispositifs RF, on connaît les substrats à base de silicium haute résistivité comprenant un substrat support, une couche de piégeage disposée sur le substrat support, une couche diélectrique disposée sur la couche de piégeage, et une couche de semi-conducteur disposée sur la couche diélectrique. Le substrat support présente habituellement une résistivité supérieure à 1 kOhm.cm. La couche de piégeage peut comprendre du silicium poly-cristallin non dopé. La combinaison d'un substrat support haute résistivité et d'une couche de piégeage selon l'état de l'art permet de réduire le couplage dispositif/substrat cité précédemment, et ainsi d'assurer de bonnes performances des dispositifs RF. A cet égard, l'homme du métier trouvera une revue des performances des dispositifs RF fabriqués sur le substrat semi-conducteur haute résistivité connu de l'état de la technique dans « Silicon-on-insulator (SOI) Technology, manufacture and applications », points 10.7 et 10.8, Oleg Kononchuk et Bich-Yen Nguyen, chez Woodhead Publishing. On pourra également se référer au document WO2016087728, qui propose une structure pour applications radiofréquences comprenant une couche de piégeage particulière.

Par ailleurs, pour la réalisation de dispositifs RF tels que par exemple des commutateurs d'antenne, contenus notamment dans les téléphones portables, il est habituel de connecter en série une pluralité de transistors (par exemple transistors à effet de champ « FET » : pour « field effect transistor » selon la terminologie anglo-saxonne) pour tenir la tension maximale s'appliquant aux bornes du commutateur, celle-ci étant plus élevée que la tension de claquage de chaque transistor individuel. Mais la mise en série de plusieurs transistors présente l'inconvénient d'augmenter la résistance série du dispositif RF, ce qui peut notamment dégrader les performances de linéarité du dispositif RF.

Le document US2016/336991 propose une solution pour améliorer les performances de dispositifs RF sur SOI, comportant notamment une couche de contact connectée électriquement au substrat support.

### OBJET DE L'INVENTION

La présente invention vise à pallier tout ou partie des inconvénients précités. Un objet de l'invention est notamment de proposer une structure pour application radiofréquence permettant l'élaboration de dispositifs RF avec des performances améliorées.

### BREVE DESCRIPTION DE L'INVENTION

La présente invention concerne une structure pour application radiofréquence selon la revendication 1.

Selon d'autres caractéristiques avantageuses et non limitatives de l'invention, prises seules ou selon toute combinaison techniquement réalisable :
- l'électrode est disposée entre la couche active et la première couche diélectrique, la deuxième couche diélectrique étant en contact avec la couche active, selon le plan principal ;
- l'électrode est disposée entre la première couche diélectrique et la couche de piégeage de charges, la deuxième couche diélectrique étant en contact avec la couche de piégeage, selon le plan principal ;
- l'électrode enterrée est discontinue dans le plan principal et une pluralité de zones de piégeage de charges s'étendent entre la première couche diélectrique et la couche de piégeage de charges, les zones de piégeage étant isolées des pavés conducteurs par les parois isolantes ;
- la structure comprend une troisième couche diélectrique, entre la couche de piégeage de charges et la face avant du substrat support ;
- l'électrode est disposée dans la couche de piégeage de charges, la deuxième couche diélectrique étant en contact avec la face avant du substrat support selon le plan principal, et dans laquelle l'électrode comprend une pluralité de parois isolantes s'étendant entre la première et la deuxième couche diélectrique et définissant une pluralité de pavés conducteurs de la couche conductrice, chaque pavé conducteur étant isolé d'au moins une zone de piégeage formant la couche de piégeage, par les parois isolantes ;
- au moins un pavé conducteur est connecté électriquement à un plot de contact disposé sur une face libre de la couche active, par un via conducteur traversant une partie de la structure pour aller du pavé conducteur au plot de contact ;
- la structure comprend en outre un dispositif dans et/ou sur la couche active, comportant au moins un transistor dont une électrode de grille disposée sur la face libre de la couche active est en vis-à-vis avec au moins un pavé conducteur de l'électrode enterrée ;
- la deuxième couche diélectrique présente une épaisseur comprise entre 5nm et 100nm ;
- la couche conductrice comprend un matériau choisi parmi le silicium monocristallin, le silicium polycristallin, le silicium amorphe ;
- la couche conductrice présente une résistivité comprise entre quelques ohms.cm et quelques milliers d'ohms.cm ;
- la couche conductrice présente une épaisseur comprise entre 50nm et 500nm ;
- la couche conductrice est formée par un matériau compatible avec des traitements à hautes températures.

### BREVE DESCRIPTION DES DESSINS

D'autres caractéristiques et avantages de l'invention ressortiront de la description détaillée qui va suivre en référence aux figures annexées sur lesquelles :
- les figures 1a et 1b présentent des structures selon un premier mode de réalisation de l'invention ;
- les figures 2a et 2b présentent des structures selon un deuxième mode de réalisation de l'invention ;
- la figure 3 présente une structure selon un troisième mode de réalisation de l'invention ;
- la figure 4 présente des structures selon un quatrième mode de réalisation de l'invention ;
- les figures 5a et 5b présentent des structures conformes à l'invention.

### DESCRIPTION DETAILLEE DE L'INVENTION

Dans la partie descriptive, les mêmes références sur les figures pourront être utilisées pour des éléments de même nature.

Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

L'invention concerne une structure 100 pour application radiofréquence comprenant un substrat support 1 à haute résistivité. Par haute résistivité, on entend une résistivité supérieure à 1000 ohm.cm ; elle est avantageusement comprise entre 4 et 10 kohm.cm. Le substrat support 1 peut être constitué de matériaux utilisés habituellement dans l'industrie de la micro-électronique, de l'optique, de l'opto-électronique, du photovoltaïque. Notamment, le substrat support 1 peut comprendre au moins un matériau sélectionné dans le groupe suivant : silicium, silicium germanium, carbure de silicium, etc.

La face avant la du substrat support 1 définit un plan principal (x,y) comme illustré sur la figure la. Avantageusement, le substrat support 1 présente une forme de plaquette circulaire, de diamètre 150, 200, 300, voire 450mm.

La structure 100 comprend également une couche de piégeage de charges 2 disposée sur la face avant la du substrat support 1. Par disposée, on entend que la couche de piégeage 2 peut être soit directement en contact avec la face avant la du substrat support 1, soit solidaire de celui-ci par l'intermédiaire d'une ou plusieurs couches intercalaires. Le terme « disposé » utilisé par la suite devra être interprété de manière similaire.

Avantageusement, la couche de piégeage 2 comprend un matériau de type silicium polycristallin, dont la densité de défauts est favorable au piégeage de charges électriques libres, aptes à se développer dans le substrat support 1. Bien-sur, la couche de piégeage 2 pourra également comprendre d'autres types de matériaux aptes à assurer la fonction de piégeage et compatibles avec la structure 100 et son utilisation. La couche de piégeage 2 présente une épaisseur comprise entre quelques dizaines de nanomètres et quelques microns, par exemple entre 50 nm et 3 microns.

La structure 100 comprend en outre une première couche diélectrique 3 disposée sur la couche de piégeage 2. La première couche diélectrique 3 va constituer dans certains modes de réalisation selon l'invention, la couche isolante enterrée de la structure 100, qui va en particulier isoler électriquement la couche active 4 du substrat support 1. Avantageusement, sans toutefois que cela soit limitatif, la première couche diélectrique 3 comprendra au moins l'un des matériaux parmi : dioxyde de silicium, nitrure de silicium, oxyde d'aluminium... Son épaisseur peut par exemple varier entre 10nm et 3µm.

La structure 100 comprend également une couche active 4 disposée sur la première couche diélectrique 3. La couche active 4 correspond à la couche dans et/ou sur laquelle des composants RF pourront être élaborés. Elle comporte une face libre ou face avant 4a et une face arrière 4b solidaire des couches sous jacentes. La couche active 4 pourra avantageusement être constituée de matériaux semi-conducteurs et/ou de matériaux piézoélectriques. Avantageusement, sans toutefois que cela soit limitatif, la couche active 4 comprend au moins l'un des matériaux parmi : silicium, carbure de silicium, silicium germanium, niobate de lithium, tantalate de lithium, quartz, nitrure d'aluminium... La couche active 4 peut présenter une épaisseur allant de quelques nanomètres (par exemple 10nm) à quelques microns, voire quelques dizaines de microns (par exemple 50µm), selon les composants à fabriquer.

Enfin, la structure 100 selon l'invention comprend au moins une électrode enterrée 10 disposée au-dessus ou dans la couche de piégeage 2 : la figure la illustre un mode de réalisation dans lequel l'électrode enterrée 10 est située au-dessus de la couche de piégeage 2 ; en particulier, elle est située juste en-dessous de la couche active 4.

L'électrode enterrée 10 comprend une couche conductrice électrique 11 et une couche diélectrique 13 (appelée par la suite deuxième couche diélectrique 13). L'électrode enterrée 10 est destinée à être polarisée par l'application d'une tension à la couche conductrice 11, et à générer un effet sur les porteurs électriques de la couche active 4.

Préférentiellement, sans toutefois que cela soit limitatif, la couche conductrice 11 comprend un matériau choisi parmi le silicium monocristallin, le silicium polycristallin, le silicium amorphe, ... ou autres matériaux habituellement utilisés pour la fabrication des électrodes de grille ou des résistances en microélectronique. Le matériau formant la couche conductrice 11 présente avantageusement une résistivité allant de quelques ohms.cm à quelques milliers d'ohms.cm. Il sera préférentiellement choisi pour être compatible avec des traitements à hautes températures, la structure 100 étant susceptible d'être soumise à de tels traitements pour la fabrication des composants radiofréquences. La couche conductrice 11 présente une épaisseur typique comprise entre 50nm et 500nm.

Préférentiellement, la deuxième couche diélectrique 13 peut comprendre au moins l'un des matériaux parmi : dioxyde de silicium, nitrure de silicium, oxyde d'aluminium... Elle présente avantageusement une épaisseur comprise entre 5nm et 100nm. Néanmoins, son épaisseur pourra varier entre 1nm et 3µm, selon les modes de réalisation de l'invention.

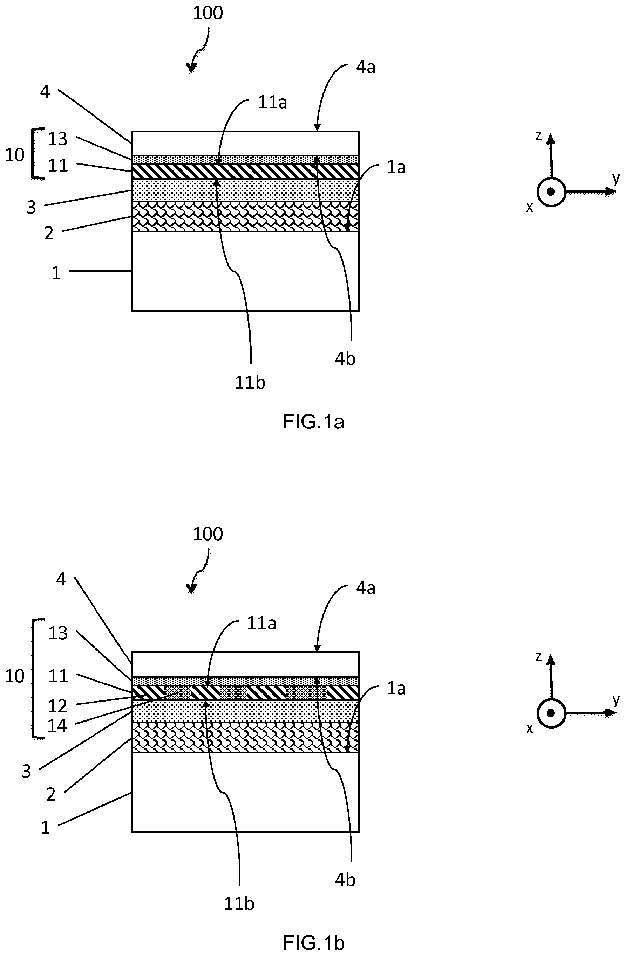

La couche conductrice 11 présente deux faces 11a, 11b selon le plan principal (x,y) : dans l'exemple de la figure 1a, la première face 11a est en contact avec la deuxième couche diélectrique 13 et la deuxième face 11b est en contact avec la première couche diélectrique 3.

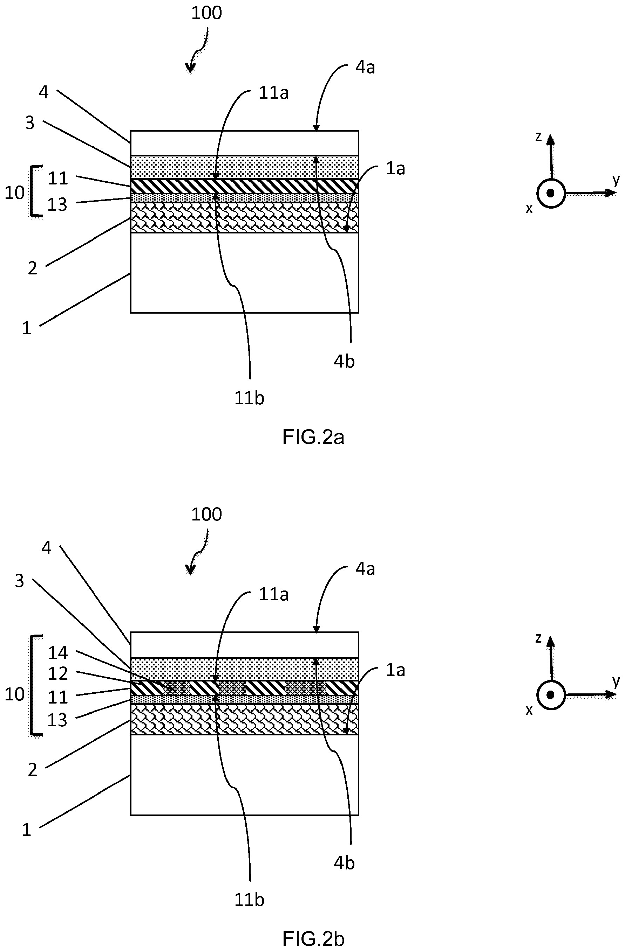

L'électrode 10 comprend une pluralité de parois 14 isolantes électriquement, s'étendant entre la première couche diélectrique 3 et la deuxième couche diélectrique 13 (figures 1b et 2b). Les dites parois isolantes 14 segmentent la couche conductrice 11 en une pluralité de pavés conducteurs 12, isolés les uns des autres par lesdites parois isolantes 14.

Selon l'invention, il sera ainsi possible d'appliquer une tension électrique à au moins un pavé conducteur 12 de l'électrode enterrée 10, qui est isolé électriquement des autres couches de la structure 100, et notamment de la couche active 4 et du substrat support 1. Le pavé conducteur 12 est avantageusement situé au moins en vis-à-vis de la région active d'un transistor qui sera élaboré dans la couche active 4 : ledit transistor peut alors bénéficier d'une polarisation au niveau de la face arrière 4b de la couche active 4, en plus de sa polarisation habituelle par une électrode de grille. L'utilisation d'une polarisation arrière (« back bias » selon la terminologie anglo-saxonne) permet d'augmenter la tension de claquage du transistor et ainsi limite le nombre de transistors à mettre en série pour supporter la tension appliquée aux bornes du dispositif RF (commutateur par exemple). La résistance série du dispositif peut être réduite et sa linéarité est améliorée.

Selon un premier mode de réalisation, illustré sur les figures la et 1b, l'électrode 10 est disposée entre la couche active 4 et la première couche diélectrique 3, la deuxième couche diélectrique 13 étant en contact avec la couche active 4, selon le plan principal (x,y).

Dans ce cas, la deuxième couche diélectrique 13 présente une épaisseur inférieure à 400nm, préférentiellement de l'ordre de 50 - 100 nm, de sorte que la tension appliquée à la couche conductrice 11 de l'électrode enterrée 10 puisse avoir un effet sur les porteurs électriques de la couche active 4.

La structure 100 présentée sur la figure la peut être élaborée par différents procédés. Certaines variantes de fabrication sont décrites ci-après.

La couche de piégeage de charges 2 est tout d'abord déposée sur le substrat support 1. A titre d'exemple, une couche de silicium polycristallin constituant la couche de piégeage 2 pourra être déposée par une technique de dépôt chimique en phase vapeur ou en phase liquide ou encore par épitaxie sur un substrat support 1 en silicium. La couche de piégeage 2 a une épaisseur comprise dans la gamme énoncée précédemment, par exemple de l'ordre de 2 microns.

La couche active 4 est reportée sur le substrat support 1 comportant la couche de piégeage 2, par une des techniques de transfert de couches minces basés sur un collage par adhésion moléculaire : en effet, un tel collage direct présente l'avantage d'une parfaite compatibilité avec des traitements à hautes températures. Parmi ces techniques de transfert de couches minces, on peut notamment citer :
- le procédé Smart Cut^{™}, basé sur une implantation d'ions légers d'hydrogène et/ou d'hélium dans un substrat donneur (duquel est issue la couche active 4), et un assemblage par adhésion moléculaire de ce substrat donneur avec le substrat support 1 ; une étape de détachement permet ensuite de séparer une couche mince superficielle du substrat donneur (la couche active 4), au niveau du plan de fragilisation défini par la profondeur d'implantation des ions. Des étapes de finition, pouvant inclure des traitements thermiques à haute température, confèrent enfin la qualité cristalline et de surface requise à la couche active 4. Ce procédé est particulièrement adapté pour la fabrication de couches actives minces, d'épaisseur comprise entre quelques nanomètres et environ 1,5µm par exemple pour les couches de silicium
- le procédé Smart Cut suivi d'une étape d'épitaxie, permettant notamment d'obtenir des couches actives plus épaisses, par exemple de quelques dizaines de nm à 20µm.
- les procédés de collage direct et d'amincissements mécanique, chimique et/ou mécano-chimique ; ils consistent à assembler le substrat donneur (duquel est issue la couche active 4) par adhésion moléculaire avec le substrat support 1, puis à amincir le substrat donneur jusqu'à l'épaisseur souhaitée de couche active 4, par exemple par rodage (« grinding » selon la terminologie anglo-saxonne) et par polissage (CMP pour « chemical mechanical polishing »). Ces procédés sont particulièrement adaptés au report de couches épaisses, par exemple de quelques microns à plusieurs dizaines de microns, et jusqu'à quelques centaines de microns.

Compte tenu des techniques de transfert de couches précités, il convient de définir sur quel substrat entre le substrat donneur (duquel est issue la couche active 4) ou le substrat support 1 (sur lequel est déposée la couche de piégeage 2), les couches intermédiaires telles que la première couche diélectrique 3, la couche conductrice 11 et la deuxième couche diélectrique 13 de l'électrode 10 (figure la) seront formées, préalablement à l'assemblage par adhésion moléculaire des deux substrats, au niveau d'une interface de collage.

Selon une première option d'assemblage, l'interface de collage se situe entre la deuxième couche diélectrique 13 et la couche conductrice 11. Cela signifie d'une part, que la deuxième couche diélectrique 13 a été formée sur le substrat donneur ; à titre d'exemple, cette couche est constituée d'une couche d'oxyde de silicium, crue thermiquement sur le substrat donneur. D'autre part, la première couche diélectrique 3, puis la couche conductrice 11, sont successivement déposées sur la couche de piégeage 2. La première couche diélectrique 3 consiste par exemple en une couche d'oxyde de silicium crue thermiquement sur la couche de piégeage 2 ou déposée par dépôt chimique ; la couche conductrice 11 est constituée d'une couche de silicium polycristallin, dont la résistivité pourra être comprise entre quelques ohms.cm et quelques kohms.cm. Dans la configuration illustrée sur la figure 1b, la couche conductrice 11 comprend des parois isolantes 14, qui définissent une pluralité de pavés conducteurs 12. Comme bien connu par l'homme du métier, la formation de la couche conductrice 11 nécessite alors au moins une étape de lithographie et gravure pour définir la répartition dans le plan (x,y) des pavés conducteurs 12 et des parois isolantes 14 et les former successivement.

Selon une deuxième option d'assemblage, l'interface de collage se situe entre la couche conductrice 11 et la première couche diélectrique 3. Dans ce cas, la deuxième couche diélectrique 13 est formée sur le substrat donneur, puis la couche conductrice 11 est formée sur la deuxième couche diélectrique 13. D'autre part, la première couche diélectrique 3 est déposée sur la couche de piégeage 2 solidaire du substrat support 1.

Selon une troisième option d'assemblage, l'interface de collage se situe entre la première couche diélectrique 3 et la couche de piégeage 2. Dans ce cas, la deuxième couche diélectrique 13 est d'abord formée sur le substrat donneur, puis la couche conductrice 11 est formée sur la deuxième couche diélectrique 13, enfin la première couche diélectrique 3 est formée sur la couche conductrice 11.

Bien-sur, d'autres options d'assemblage existent, pour lesquelles notamment l'interface de collage peut se situer dans l'une des couches intermédiaires, par exemple au milieu de la première couche diélectrique 3. Par exemple, une première partie de la première couche diélectrique 3 est formée sur le substrat donneur (duquel est issue la couche active 4) ; une seconde partie de la première couche diélectrique 3 est formée du côté du substrat support 1, après la formation des couches sous jacentes.

Dans chacune des options d'assemblage précitées, les substrats donneur et support, munis de leurs couches respectives, sont assemblés par adhésion moléculaire. La mise en œuvre de l'une ou l'autres des techniques de transfert de couches précédentes mène ensuite à la formation de la couche active 4.

Selon un deuxième mode de réalisation illustré sur les figures 2a et 2b, l'électrode 10 est disposée entre la première couche diélectrique 3 et la couche de piégeage de charges 2, la deuxième couche diélectrique 13 étant en contact avec la couche de piégeage, selon le plan principal (x,y). La première face 11a de la couche conductrice 11 est en contact avec la première couche diélectrique 3 et sa deuxième face 11b est en contact avec la deuxième couche diélectrique 13.

Dans ce cas, la première couche diélectrique 3 présente une épaisseur inférieure à 400nm, préférentiellement inférieure à 200 nm, de sorte que la tension appliquée à la couche conductrice 11 de l'électrode enterrée 10 puisse avoir un effet sur les porteurs électriques de la couche active 4. La deuxième couche diélectrique 13 peut quant à elle présenter une épaisseur jusqu'à quelques microns, si cela est requis pour l'application.

Les techniques de transfert de couches et de réalisation de parois isolantes 14 dans la couche conductrice 11 énoncées dans le premier mode de réalisation s'appliquent également à ce deuxième mode de réalisation. Différentes options d'assemblage peuvent être mise en œuvre, selon que la formation des couches intermédiaires de la structure 100 (première couche diélectrique 3, couche conductrice 11 et deuxième couche diélectrique 13) est opérée sur le substrat donneur ou le substrat support 1.

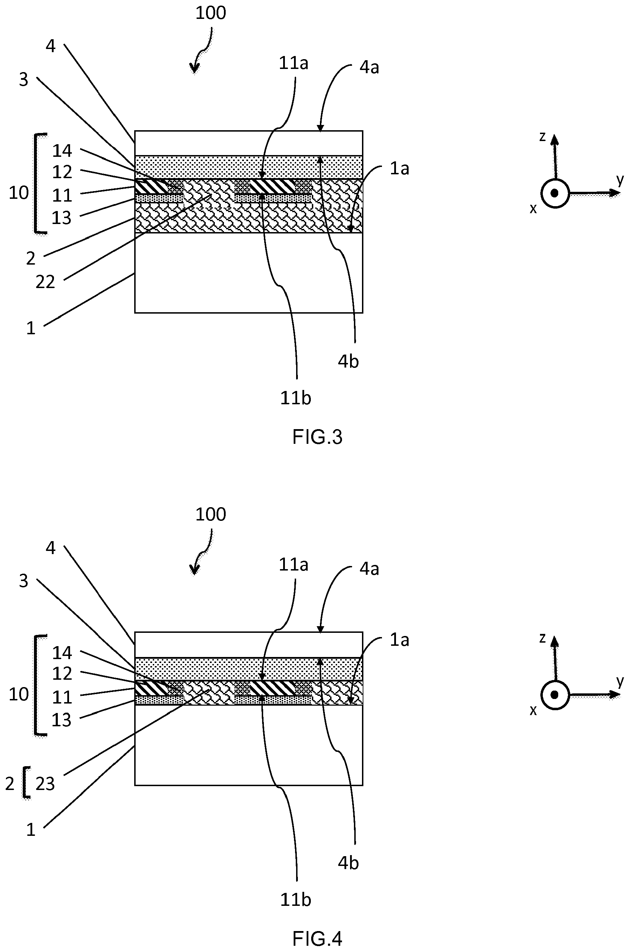

Selon un troisième mode de réalisation, illustré sur la figure 3, l'électrode 10 est disposée comme précédemment entre la première couche diélectrique 3 et la couche de piégeage de charges 2 et elle comporte des pavés conducteurs 12 isolés électriquement entre eux par des parois isolantes 14 ; par ailleurs, l'électrode enterrée 10 est discontinue dans le plan principal (x,y) et une pluralité de zones de piégeage de charges 22 s'étendent entre la première couche diélectrique 3 et la couche de piégeage de charges 2. Les zones de piégeage 22 sont isolées des pavés conducteurs 12 par les parois isolantes 14.

Les zones de piégeage 22 pourront être constituées par le même matériau que la couche de piégeage 2 ou par un matériau différent, présentant des propriétés de piégeage des charges électriques.

Dans ce troisième mode de réalisation de l'invention, la première couche diélectrique 3 présente une épaisseur inférieure à 400nm, préférentiellement inférieure à 200 nm, de sorte que la tension appliquée à la couche conductrice 11 de l'électrode enterrée 10 puisse avoir un effet sur les porteurs électriques de la couche active 4.

Les techniques de transfert de couches détaillées pour le premier mode de réalisation s'appliquent également à ce troisième mode de réalisation. Avantageusement, une option d'assemblage consistant à placer l'interface de collage dans la première couche diélectrique 3 sera mise en œuvre. Une première partie de la première couche diélectrique 3 est formée sur le substrat donneur (duquel est issue la couche active 4) ; une seconde partie de la première couche diélectrique 3 est formée du côté du substrat support 1, après la formation des couches sous jacentes. La couche de piégeage 2 est d'abord élaborée sur le substrat support 1. La deuxième couche diélectrique 13 est ensuite déposée (dépôt chimique ou croissance thermique). Une étape de lithographie et de gravure permet d'éliminer la deuxième couche diélectrique 13 au niveau des futures zones de piégeage 22. D'autres étapes de masquage, dépôt et gravure successives permettent ensuite de former les pavés conducteurs 12, les parois isolantes 14 et les zones de piégeage 22. La seconde partie de la première couche diélectrique 3 est alors déposée au-dessus des pavés conducteurs 12, des parois isolantes 14 et des zones de piégeage 22. Une étape de planarisation de cette seconde partie de la première couche diélectrique 3 permet alors d'obtenir un bon état de surface en vue d'un collage direct.

Les substrats donneur et support, munis de leurs couches respectives, sont ensuite assemblés par adhésion moléculaire. La mise en œuvre de l'une ou l'autre des techniques de transfert de couches précédemment énoncées mène ensuite à la formation de la couche active 4.

Selon un quatrième mode de réalisation illustré sur la figure 4, l'électrode 10 est disposée dans la couche de piégeage de charges 2. La deuxième couche diélectrique 13 est en contact avec la face avant la du substrat support 1 selon le plan principal (x, y). L'électrode 10 comprend une pluralité de parois isolantes 14 s'étendant entre la première 3 et la deuxième 13 couche diélectrique et définissant une pluralité de pavés conducteurs 12 de la couche conductrice 11, isolés les uns des autres par lesdites parois isolantes 14. Chaque pavé conducteur 12 est isolé électriquement d'au moins une zone de piégeage de charges 23 formant la couche de piégeage 2, par les parois isolantes 14. La zone de piégeage de charges 23 s'étend entre la première couche diélectrique 3 et le substrat support 1.

Selon une variante applicable aux différents modes de réalisation précédemment énoncés, la structure 100 peut comprendre une troisième couche diélectrique 30, disposée entre la couche de piégeage 2 (ou les zones de piégeage de charges 23) et le substrat support 1. Elle peut comprendre au moins l'un des matériaux parmi : dioxyde de silicium, nitrure de silicium, oxyde d'aluminium, etc. Elle est notamment avantageuse en ce qu'elle empêche ou tout au moins limite fortement la recristallisation de la couche de piégeage 2, lorsque celle-ci est par exemple en silicium poly-cristallin) lors les traitements thermiques à hautes températures susceptibles d'être appliqués pour la fabrication de la structure selon l'invention.

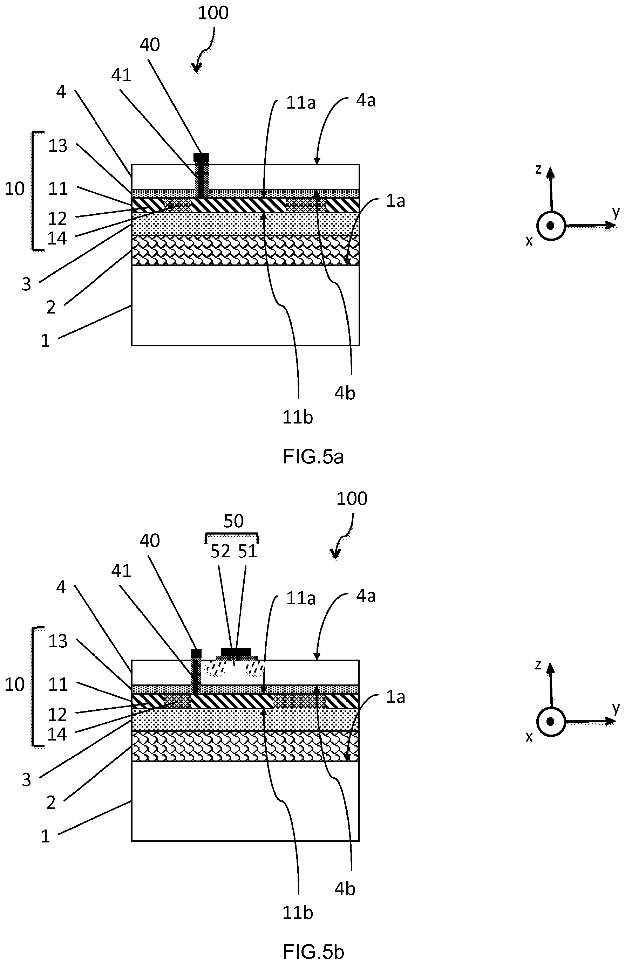

Dans la structure 100 selon l'un ou l'autre des modes de réalisation énoncés, au moins un pavé conducteur 12 peut être connecté électriquement à un plot de contact 40 par un via conducteur 41. Ce dernier traverse une partie de la structure 100 pour aller du pavé conducteur 12 audit plot de contact 40 ; dans l'exemple de la figure 5a, le via conducteur 41 traverse en particulier la couche active 4 et la deuxième couche diélectrique 13. Le plot de contact 40 est disposé sur une face libre 4a de la couche active 4, isolé électriquement de celle-ci.

Le plot de contact 40 est formé par un matériau conducteur électrique par l'intermédiaire duquel une tension pourra être appliquée au pavé conducteur 12 de l'électrode enterrée 10. Le via conducteur 41 est formé, par les techniques connues de l'homme du métier, en réalisant une tranchée dont les parois sont isolées électriquement des couches qu'elle traverse et qui est remplie par un matériau conducteur, par exemple du silicium poly-cristallin dopé.

Une pluralité de vias conducteurs 41 pourront être réalisés pour connecter indépendamment chaque pavé conducteur 12 enterré à un plot de contact 40.

Des marques d'alignement auront avantageusement été formées sur le substrat support 1 (ou sur le substrat donneur duquel est issue la couche active 4) lors de l'élaboration des pavés conducteurs 12. Ces marques d'alignement sont utilisées lors des étapes de fabrication des vias conducteurs 41, afin de former les vias à l'aplomb des pavés conducteurs 12.

La structure 100 peut également comprendre un dispositif dans et/ou sur la couche active 4, comportant au moins un transistor 50 dont une électrode de grille 51 disposée sur la face libre 4a de la couche active 4 est en vis-à-vis avec au moins un pavé conducteur 12 de l'électrode enterrée 10 (figure 5b). Les marques d'alignement formées lors de l'élaboration des pavés conducteurs 12 de l'électrode enterrée 10 sont également utilisés lors des étapes de fabrication du dispositif électronique sur la couche active 4.

La structure 100 selon l'invention est particulièrement adaptée aux dispositifs radiofréquences tels que notamment des commutateurs ou adaptateurs d'antenne pour les téléphones cellulaires. L'intégration de l'électrode enterrée 10 dans la structure 100 permet une fabrication plus aisée des dispositifs comportant des transistors avec « back bias ». L'utilisation d'une électrode enterrée 10 pour polariser la région active 52 d'un transistor 50 par la face arrière (« back bias ») permet d'augmenter la tension de claquage du transistor et ainsi de limiter le nombre de transistors à mettre en parallèle dans chaque dispositif. Enfin, la présence de la couche de piégeage de charges 2 dans la structure 100 assure le maintien d'une haute résistivité du substrat support 1.

La structure 100 selon l'invention permet ainsi d'atteindre de hautes performances dans le domaine des applications hautes fréquences.

Bien-sur, l'invention n'est pas limitée aux modes de réalisation décrits et on peut y apporter des variantes de réalisation sans sortir du cadre de l'invention tel que défini par les revendications.

## Revendications

1. Structure (100) pour application radiofréquence comprenant :
• Un substrat support (1) à haute résistivité dont une face avant (1a) définit un plan principal,
• Une couche de piégeage de charges (2) disposée sur la face avant (1a) du substrat support (1),
• Une première couche diélectrique (3) disposée sur la couche de piégeage (2),
• Une couche active (4) disposée sur la première couche diélectrique (3),
la structure (100) étant **caractérisée en ce qu'elle** comprend au moins une électrode enterrée (10) disposée au-dessus ou dans la couche de piégeage (2), l'électrode (10) comprenant :
• une couche conductrice (11) et une deuxième couche diélectrique (13), la couche conductrice (11) étant électriquement isolée de la couche active (4), de la couche de piégeage (2) et du substrat support (1), et la couche conductrice (11) présentant deux faces (lla,llb) selon le plan principal, une face étant en contact avec la première couche diélectrique (3) et une autre face étant en contact avec la deuxième couche diélectrique (13),
• une pluralité de parois isolantes (14) s'étendant entre la première (3) et la deuxième (13) couche diélectrique et segmentant la couche conductrice (11) en une pluralité de pavés conducteurs (12), lesdits pavés (12) étant isolés les uns des autres par les parois isolantes (14), au moins un pavé conducteur (12) étant configuré pour procurer une polarisation arrière à un transistor destiné à être élaboré dans la couche active (4).

2. Structure (100) pour application radiofréquence selon la revendication précédente, dans laquelle l'électrode (10) est disposée entre la couche active (4) et la première couche diélectrique (3), la deuxième couche diélectrique (13) étant en contact avec la couche active (4), selon le plan principal.

3. Structure (100) pour application radiofréquence selon la revendication 1, dans laquelle l'électrode (10) est disposée entre la première couche diélectrique (3) et la couche de piégeage de charges (2), la deuxième couche diélectrique (13) étant en contact avec la couche de piégeage (2), selon le plan principal.

4. Structure (100) pour application radiofréquence selon la revendication précédente, dans laquelle l'électrode (10) est discontinue dans le plan principal et une pluralité de zones de piégeage de charges (22) s'étendent entre la première couche diélectrique (3) et la couche de piégeage de charges (2), les zones de piégeage (22) étant isolées des pavés conducteurs (12) par les parois isolantes (14).

5. Structure (100) pour application radiofréquence selon la revendication 1, dans laquelle l'électrode (10) est disposée dans la couche de piégeage de charges (2), la deuxième couche diélectrique (13) étant en contact avec la face avant (1a) du substrat support (1) selon le plan principal, et dans laquelle l'électrode (10) comprend une pluralité de parois isolantes (14) s'étendant entre la première (3) et la deuxième (13) couche diélectrique et définissant une pluralité de pavés conducteurs (12) de la couche conductrice (11), chaque pavé conducteur (12) étant isolé d'au moins une zone de piégeage (23) formant la couche de piégeage (2), par les parois isolantes (14).

6. Structure (100) pour application radiofréquence selon la revendication 1, dans laquelle au moins un pavé conducteur (12) est connecté électriquement à un plot de contact (40) disposé sur une face libre (4a) de la couche active (4), par un via conducteur (41) traversant une partie de la structure (100) pour aller du pavé conducteur (12) au plot de contact (40).

7. Structure (100) pour application radiofréquence selon la revendication précédente, comprenant en outre un dispositif dans et/ou sur la couche active (4), comportant au moins un transistor (50) dont une électrode de grille (51) disposée sur la face libre (4a) de la couche active (4) est en vis-à-vis avec au moins un pavé conducteur (12) de l'électrode enterrée (10).

8. Structure (100) pour application radiofréquence selon l'une des revendications précédentes, dans laquelle la deuxième couche diélectrique (13) présente une épaisseur comprise entre 5nm et 100nm.

9. Structure (100) pour application radiofréquence selon l'une des revendications précédentes, dans laquelle la couche conductrice (11) comprend un matériau choisi parmi le silicium monocristallin, le silicium poly-cristallin, le silicium amorphe.

10. Structure (100) pour application radiofréquence selon l'une des revendications précédentes, dans laquelle la couche conductrice (11) présente une épaisseur comprise entre 50nm et 500nm.

11. Structure (100) pour application radiofréquence selon l'une des revendications précédentes, dans laquelle la couche conductrice présente une résistivité comprise entre quelques ohms.cm et quelques milliers d'ohms.cm.

## Patentansprüche

1. Struktur (100) für Hochfrequenzanwendung, umfassend:
• ein Trägersubstrat (1) mit hohem spezifischem Widerstand, dessen Vorderseite (1a) eine Hauptebene definiert,
• eine auf der Vorderseite (1a) des Trägersubstrats (1) angeordnete Ladungseinfangschicht (2),
• eine auf der Einfangschicht (2) angeordnete erste dielektrische Schicht (3),
• eine auf der ersten dielektrischen Schicht (3) angeordnete aktive Schicht (4),
wobei die Struktur (100) **dadurch gekennzeichnet ist, dass** sie mindestens eine verdeckte Elektrode (10) umfasst, die über oder in der Einfangschicht (2) angeordnet ist, wobei die Elektrode (10) umfasst:
• eine leitfähige Schicht (11) und eine zweite dielektrische Schicht (13), wobei die leitfähige Schicht (11) von der aktiven Schicht (4), von der Einfangschicht (2) und von dem Trägersubstrat (1) elektrisch isoliert ist und die leitfähige Schicht (11) zwei Seiten (11a, 11b) entlang der Hauptebene aufweist, wobei eine Seite in Kontakt mit der ersten dielektrischen Schicht (3) steht und eine andere Seite in Kontakt mit der zweiten dielektrischen Schicht (13) steht,
• mehrere isolierende Wände (14), die sich zwischen der ersten (3) und der zweiten (13) dielektrischen Schicht erstrecken und die leitfähige Schicht (11) in mehrere leitfähige Pads (12) segmentieren, wobei die Pads (12) voneinander durch die isolierenden Wände (14) isoliert sind, wobei mindestens ein leitfähiges Pad (12) so konfiguriert ist, dass es einem in der aktiven Schicht (4) herzustellenden Transistor eine Rückwärtsvorspannung bereitstellt.

2. Struktur (100) für Hochfrequenzanwendung nach dem vorhergehenden Anspruch, bei der die Elektrode (10) zwischen der aktiven Schicht (4) und der ersten dielektrischen Schicht (3) angeordnet ist, wobei die zweite dielektrische Schicht (13) entlang der Hauptebene mit der aktiven Schicht (4) in Kontakt steht.

3. Struktur (100) für Hochfrequenzanwendung nach Anspruch 1, bei der die Elektrode (10) zwischen der ersten dielektrischen Schicht (3) und der Ladungseinfangschicht (2) angeordnet ist, wobei die zweite dielektrische Schicht (13) entlang der Hauptebene mit der Einfangschicht (2) in Kontakt steht.

4. Struktur (100) für Hochfrequenzanwendung nach dem vorhergehenden Anspruch, bei der die Elektrode (10) in der Hauptebene diskontinuierlich ist und sich eine Vielzahl von Ladungseinfangzonen (22) zwischen der ersten dielektrischen Schicht (3) und der Ladungseinfangschicht (2) erstrecken, wobei die Einfangzonen (22) von den leitfähigen Pads (12) durch die isolierenden Wände (14) isoliert sind.

5. Struktur (100) für Hochfrequenzanwendung nach Anspruch 1, bei der die Elektrode (10) in der Ladungseinfangschicht (2) angeordnet ist, wobei die zweite dielektrische Schicht (13) mit der Vorderseite (1a) des Trägersubstrats (1) entlang der Hauptebene in Kontakt steht und bei dem die Elektrode (10) mehrere isolierende Wände (14) umfasst, die sich zwischen der ersten (3) und der zweiten (13) dielektrischen Schicht erstrecken und mehrere leitfähige Pads (12) der leitfähigen Schicht (11) definieren, wobei jedes leitfähige Pad (12) durch die isolierenden Wände (14) von mindestens einer Einfangzone (23) isoliert ist, die die Einfangschicht (2) bildet.

6. Struktur (100) für Hochfrequenzanwendung nach Anspruch 1, bei der mindestens ein leitfähiges Pad (12) elektrisch mit einer Kontaktanschlussfläche (40), die auf einer freien Seite (4a) der aktiven Schicht (4) angeordnet ist, durch eine leitfähige Durchkontaktierung (41) verbunden ist, die durch einen Teil der Struktur (100) hindurchgeht, um vom leitfähigen Pad (12) zur Kontaktanschlussfläche (40) zu verlaufen.

7. Struktur (100) für Hochfrequenzanwendung nach dem vorhergehenden Anspruch, die ferner eine Vorrichtung in und/oder auf der aktiven Schicht (4) umfasst, die mindestens einen Transistor (50) umfasst, dessen eine Gate-Elektrode (51), die auf der freien Seite (4a) der aktiven Schicht (4) angeordnet ist, sich gegenüber mindestens einem leitfähigen Pad (12) der verdeckten Elektrode (10) befindet.

8. Struktur (100) für Hochfrequenzanwendung nach einem der vorhergehenden Ansprüche, bei der die zweite dielektrische Schicht (13) eine Dicke zwischen 5 nm und 100 nm aufweist.

9. Struktur (100) für Hochfrequenzanwendung nach einem der vorhergehenden Ansprüche, bei der die leitfähige Schicht (11) ein Material umfasst, das aus monokristallinem Silizium, polykristallinem Silizium, amorphem Silizium ausgewählt ist.

10. Struktur (100) für Hochfrequenzanwendung nach einem der vorhergehenden Ansprüche, bei der die leitfähige Schicht (11) eine Dicke zwischen 50 nm und 500 nm aufweist.

11. Struktur (100) für Hochfrequenzanwendung nach einem der vorhergehenden Ansprüche, bei der die leitfähige Schicht einen spezifischen Widerstand zwischen einigen Ohm·cm und einigen tausend Ohm·cm aufweist.

## Claims

1. Structure (100) for radio frequency applications comprising:
• a high-resistivity support substrate (1) having a front surface (1a) which defines a main plane,
• a charge-trapping layer (2) which is arranged on the front face (1a) of the support substrate (1),
• a first dielectric layer (3) which is arranged on the trapping layer (2),
• an active layer (4) which is arranged on the first dielectric layer (3),
the structure (100) being **characterized in that** it comprises at least one buried electrode (10) which is arranged above or in the trapping layer (2), the electrode (10) comprising:
• a conductive layer (11) and a second dielectric layer (13), the conductive layer (11) being electrically insulated from the active layer (4), from the trapping layer (2) and from the support substrate (1), and the conductive layer (11) having two surfaces (11a, 11b) parallel to the main plane, one surface being in contact with the first dielectric layer (3) and the other surface being in contact with the second dielectric layer (13),
• a plurality of insulating walls (14) extending between the first dielectric layer (3) and the second dielectric layer (13) and segmenting the conductive layer (11) into a plurality of conductive blocks (12), said blocks (12) being insulated from one another by the insulating walls (14), at least one conductive block (12) being configured to provide a rear bias to a transistor which is intended to be produced in the active layer (4).

2. Structure (100) for radio frequency applications according to the preceding claim, wherein the electrode (10) is arranged between the active layer (4) and the first dielectric layer (3), the second dielectric layer (13) being in contact with the active layer (4), parallel to the main plane.

3. Structure (100) for radio frequency applications according to claim 1, wherein the electrode (10) is arranged between the first dielectric layer (3) and the charge-trapping layer (2), the second dielectric layer (13) being in contact with the trapping layer (2), parallel to the main plane.

4. Structure (100) for radio frequency applications according to the preceding claim, wherein the electrode (10) is discontinuous in the main plane and a plurality of charge-trapping zones (22) extend between the first dielectric layer (3) and the charge-trapping layer (2), the trapping zones (22) being insulated from the conductive blocks (12) by the insulating walls (14).

5. Structure (100) for radio frequency applications according to claim 1, wherein the electrode (10) is arranged in the charge-trapping layer (2), the second dielectric layer (13) being in contact with the front surface (1a) of the support substrate (1) parallel to the main plane, and wherein the electrode (10) comprises a plurality of insulating walls (14) extending between the first dielectric layer (3) and the second dielectric layer (13) and defining a plurality conductive blocks (12) of the conductive layer (11), each conductive block (12) being insulated from at least one trapping zone (23) forming the trapping layer (2) by the insulating walls (14).

6. Structure (100) for radio frequency applications according to claim 1, wherein at least one conductive block (12) is electrically connected to a contact pad (40), which is arranged on a free surface (4a) of the active layer (4), by means of a conductive via (41) which passes through part of the structure (100) in order to go from the conductive block (12) to the contact pad (40).

7. Structure (100) for radio frequency applications according to the preceding claim, further comprising a device in and/or on the active layer (4) including at least one transistor (50) of which a gate electrode (51) arranged on the free surface (4a) of the active layer (4) faces at least one conductive block (12) of the buried electrode (10).

8. Structure (100) for radio frequency applications according to any of the preceding claims, wherein the second dielectric layer (13) has a thickness of between 5 nm and 100 nm.

9. Structure (100) for radio frequency applications according to any of the preceding claims, wherein the conductive layer (11) comprises a material selected from monocrystalline silicon, polycrystalline silicon or amorphous silicon.

10. Structure (100) for radio frequency applications according to any of the preceding claims, wherein the conductive layer (11) has a thickness of between 50 nm and 500 nm.

11. Structure (100) for radio frequency applications according to any of the preceding claims, wherein the conductive layer has a resistivity of between a few ohms.cm and a few thousand ohms.cm.
